# EUROPÄISCHE PATENTSCHRIFT

(11) **EP 2 819 136 B1**
(45) Veröffentlichungstag und Bekanntmachung des Hinweises auf die Patenterteilung: **29.03.2017**
(21) Anmeldenummer: 14179178.0
(22) Anmeldetag: 20.04.2012
(51) Int. Cl.: H01H 3/02

(54) **Nottaste mit verschiebbar gelagertem Anzeigedisplay**
Emergency stop button with moveably mounted display panel
Bouton d'urgence doté d'un affichage déplaçable

(30) Priorität: 29.04.2011 DE 102011100036
(43) Veröffentlichungstag der Anmeldung: 31.12.2014
(62) Teilanmeldung aus: 12002788.3
(73) Patentinhaber: ASSA ABLOY Sicherheitstechnik GmbH, 72458 Albstadt (DE)
(72) Erfinder: Bothur, Gerald, 72458 Albstadt (DE)
(74) Vertreter: Louis Pöhlau Lohrentz

(56) Entgegenhaltungen:
- EP-A2- 2 169 154
- WO-A1-2011/018439
- DE-B3-102004 042 573

## Beschreibung

Die Erfindung betrifft eine Nottaste gemäß den Merkmalen des Oberbegriffs des Anspruchs 1.

Aus der WO 2011/018439 A1 ist eine Bedienvorrichtung mit einer Taste bekannt, die ein transparentes berührungsempfindliches Eingabefeld und ein Display aufweist. Die Taste ist als Bedieneinheit für Geräte vorgesehen und weist eine Sicherheitsfunktion auf, indem für eine Schaltfunktion abgefragt wird, ob die Taste gleichzeitig mit dem Eingabefeld betätigt wird.

Die DE 10 2004 042 573 B3 zeigt einen Gefahrenmelder mit einem manuell zu betätigenden elektromechanischen Kontakt und einer Abdeckhaube.

Insbesondere in Gebäuden ist es häufig erforderlich, im Gefahrenfall schnell ein Alarmsignal auslösen zu können, um beispielsweise weitere im Gebäude befindliche Personen schnell warnen zu können. Darüber hinaus sollen in möglichst kurzer Zeit entsprechende Gegenmaßnahmen eingeleitet werden, beispielsweise durch Benachrichtigung einer Rettungsleitstelle, etc. In Gebäuden, insbesondere öffentlichen Gebäuden und Gefahrenbereichen, sind hierzu in der Regel gut sichtbar Nottasten angeordnet, die bei Betätigung ein Notsignal abgeben. Notsignal ist in diesem Zusammenhang und insbesondere im Hinblick auf die Erfindung breit zu verstehen und kann beispielsweise unmittelbar die Auslösung eines akustischen und/oder optischen Alarms darstellen. Unter dem Begriff Notsignal fällt jedoch gleichermaßen auch die
Übermittlung eines Signals an eine Rettungsleitzentrale und ähnliches. Der Begriff Notsignal umfasst somit beispielsweise auch ein elektrisches Signal und ist nicht auf unmittelbar akustisch oder optisch wahrnehmbare Signale beschränkt. Das Notsignal umfasst mit anderen Worten grundsätzlich auch solche Signale, die unmittelbar oder mittelbar, beispielsweise durch Weiterleitung an eine zentrale Stelle, angeben, dass eine Person den Nottaster betätigt hat. Das Notsignal kann zudem in einen Voralarm und einen Hauptalarm untergliedert sein. Der Voralarm soll primär den Bediener auf die mögliche Auslösung eines Alarms hinweisen. Der Hauptalarm dient dagegen primär dem konkreten Hinweis auf die Gefahrensituation. Durch Betätigung der Nottaste kann eine in Gefahr befindliche Person somit allgemein auf die Notsituation aufmerksam machen. Ein Notsignal im Sinne der vorliegenden Erfindung kann ferner ergänzend oder alternativ auch ein, optional zeitverzögertes, Öffnungssignal an ein Verschluss- oder Verriegelungselement, beispielsweise ein Öffnungssignal an einen Fluchttüröffner einer Fluchttür, sein.

Eine gattungsgemäße Nottaste umfasst ein Gehäuse und ein im Gehäuse angeordnetes, mechanisch betätigbares Schaltelement, das im betätigten Zustand zur Abgabe des Notsignals ausgebildet ist. Das Schaltelement, beispielsweise ein Druckschalter, etc., ist somit konkret derjenige Teil der Nottaste, der durch einen Schaltvorgang die Abgabe des Notsignals auslöst. Geeignete Schaltelemente für den Einsatz in einer Nottaste sind im Stand der Technik bekannt. Häufig ist das Schaltelement zur Sicherstellung eines Schaltvorgangs bei einer Betätigung des Schaltelements mit wenigstens einem zwangsöffnenden Kontakt ausgestattet, der in der Weise ausgebildet ist, dass er als direktes Ergebnis einer festgelegten Schaltbewegung zwangsläufig einen Kontakt, vorzugsweise über nicht federnde Teile, trennt. Die Nottaste erfüllt idealerweise die Anforderungen der DIN EN 13637. Das Schaltelement ist in dem Gehäuse angeordnet, welches, je nach Ausführungsform, beispielsweise zur Aufputz-oder Unterputzmontage ausgebildet sein kann. Es ist bekannt, eine gattungsgemäße Nottaste als eigenständige Einheit auszubilden und beispielsweise in einem Gefahrenbereich anzuordnen. Alternativ kann die Nottaste auch Teil einer übergeordneten Einheit, beispielsweise eines Rettungswegs-Türterminals, sein. Bei einem Rettungsweg-Türterminal handelt es sich um eine Einrichtung" in die neben der Nottasterfunktion zusätzliche Funktionen integriert sein können (insbesondere Türsteuerung, Gegensprechfunktionen, etc.). Bei diesen Ausführungsformen kann die Nottaste als eigenständiges Modul oder fest integrierte Einheit vorgesehen sein. Die Nottaste ist häufig in der Nähe einer Tür angeordnet, beispielsweise neben dem Türrahmen, um von einer in Gefahr befindlichen Person schnell gefunden und leicht bedient werden zu können.

In jüngerer Zeit werden erhöhte Anforderungen an gattungsgemäße Nottasten beziehungsweise Panikschalter gestellt. Einerseits sollen diese sofort erkennbar sein und gleichzeitig ästhetisch ansprechend ausgebildet sein. Häufig ist zudem eine kompakte Bauweise erwünscht und eine erhöhte Funktionalität. Zugleich werden allerdings erhöhte sicherheitstechnische Anforderungen an eine gattungsgemäße Nottaste gestellt, um diese möglichst ausfallsicher auszubilden.

Die Aufgabe der Erfindung besteht somit darin, eine Nottaste anzugeben, die sich durch eine hohe Funktionalität, eine kompakte und ästhetisch ansprechende Bauform und eine hohe Funktionszuverlässigkeit auszeichnet.

Die Lösung der Aufgabe gelingt mit einer Nottaste nach den Merkmalen des Anspruchs 1 sowie einem Verfahren zum Betrieb einer Nottaste gemäß den Merkmalen des Anspruchs 8.

Bevorzugte Weiterbildungen sind in den abhängigen Ansprüchen angegeben.

Die Nottaste umfasst ein bewegbar am Gehäuse gelagertes und von einer Steuereinheit angesteuertes Anzeigedisplay, über dessen Bewegung das, beispielsweise als Panikschalter ausgebildete Schaltelement mechanisch betätigbar ist. Das Anzeigedisplay weist annäherungs- und/oder berührungssensitive Elemente auf und die Auslösung eines Notsignals erfolgt kaskadiert über eine Berührung des Anzeigedisplays oder über eine Annäherung an das Anzeigedisplay und über eine Druckbetätigung des mechanischen Schaltelements, wobei dem Anzeigedisplay eine Voralarmfunktion und der mechanischen Betätigung des Schaltelementes eine Hauptalarmfunktion zugeordnet sind.

Bei dem Anzeigedisplay handelt es sich allgemein um einen Bildschirm, über den Bildinhalte wiedergegeben werden können. Das Anzeigedisplay ist dazu nach außen hin üblicherweise mit einer Anzeigefläche ausgebildet. Obwohl grundsätzlich monochrome Anzeigedisplays zum Einsatz kommen können, ist der Einsatz polychromer Bildschirme bevorzugt. Der Begriff "Anzeigedisplay" beschreibt dabei konkret den Anzeigebildschirm als Ganzes und umfasst unter anderem gegebenenfalls vorhandene Schutzelemente (wie beispielsweise eine teilweise vorhandene nach außen gerichteten Schutzscheibe und/oder -folie), bildgebende Schichten/Beschichtungen, Filterschichten, Anschlüsse zur Bildsteuerung und Stromversorgung, etc. Bei dem Anzeigedisplay kann es sich beispielsweise um einen Flüssigkristallbildschirm (LCD-Bildschirm) handeln. Die
Steuerung der angezeigten Bildinhalte, die über das Anzeigedisplay konkret angezeigt werden, erfolgt über eine geeignete Steuereinheit, die im Gehäuse der Nottaste angeordnet ist. Die Steuereinheit stellt somit ein separates Bauteil dar, das nicht zwangsläufig zusammen mit dem Anzeigedisplay bewegbar angeordnet sein muss. Die Steuereinheit kann vielmehr fest im Gehäuse angeordnet sein und ist dann über geeignete Mittel, wie beispielsweise Kabel, mit dem Anzeigedisplay verbunden.

Ein weiterer Aspekt der Erfindung liegt darin, dass das Anzeigedisplay bewegbar am Gehäuse gelagert ist. Die bewegbare Lagerung erfolgt konkret nicht willkürlich, sondern in der Weise, dass über eine Bewegung des Anzeigedisplays das Schaltelement mechanisch betätigbar ist. Das Anzeigedisplay ist somit zwischen einer Ausgangsstellung und einer Betätigungsstellung relativ zum Gehäuse bewegbar, wobei es bei der Bewegung von der Ausgangsstellung in die Betätigungsstellung das, vorzugsweise einen zwangsöffnenden Kontakt umfassende, Schaltelement mechanisch betätigt. Für den Benutzer bedeutet dies, dass er eine mechanische Auslösung des Notsignals über eine Bewegung, insbesondere Druckbetätigung, des Anzeigedisplays von der Ausgangstellung in die Betätigungsstellung erreichen kann. Der Benutzer betätigt somit das Schaltelement nicht direkt, sondern mittelbar beziehungsweise indirekt über eine Bewegung des Anzeigedisplays.

Um im Gefahrenfall eine zuverlässige Auslösung der Nottaste zu gewährleisten, ist das Anzeigedisplay vorzugsweise in der Weise angeordnet, dass es das Schaltelement nach außen hin abdeckt. Zwischen dem im Inneren des Gehäuses angeordneten Schaltelement und dem die Nottaste außerhalb des Gehäuses umgebenden Bereich ist somit das Anzeigedisplay angeordnet und schirmt das Schaltelement nach außen hin ab. Baulich erfüllt das Anzeigedisplay
somit gleichzeitig eine Abdeckfunktion, um die nach außen hin geschlossene Erscheinung des Gehäuses zu erreichen.

Die konkrete Lagerung des Anzeigedisplays am Gehäuse kann variieren. Ideal ist es dabei, wenn das Anzeigedisplay in der Weise am Gehäuse gelagert ist, dass seine Betätigungsrichtung von der Ausgangsstellung in die Betätigungsstellung zumindest teilweise in Richtung der Schaltrichtung des mechanisch betätigbaren Schaltelementes liegt. Die Schaltrichtung des Schaltelements ist diejenige Richtung, in die es bewegt werden muss, um ein Notsignal abzugeben. Neben beispielsweise einer schwenkbaren Lagerung des Anzeigedisplays am Gehäuse der Nottaste ist insbesondere eine linear verschiebliche Lagerung des Anzeigedisplays in Richtung auf das Schaltelement besonders bevorzugt. Einerseits lässt sich eine linear verschiebliche Lagerung verhältnismäßig einfach am Gehäuse erreichen und andererseits ist eine Betätigung des Anzeigedisplays bzw. eine Bewegung des Anzeigedisplays von der Ausgangsstellung in die Betätigungsstellung über die gesamte Außenfläche des Anzeigedisplays gleichermaßen möglich. Optimal ist es, wenn die Schaltrichtung des mechanischen Schaltelementes und die Bewegungsrichtung des Anzeigedisplays von der Ausgangsstellung in die betätigte Stellung parallel und ganz besonders koaxial zueinander liegen. Auf diese Weise ist eine sichere Bewegungsübertragung der Betätigungsbewegung des Anzeigedisplays auf das Schaltelement besonders gut gewährleistet.

Ideal ist es, wenn das Anzeigedisplay in einem Führungsrahmen am Gehäuse der Nottaste gelagert ist. Der Führungsrahmen weist dazu vorzugsweise Elemente auf, die eine definierte Bewegung des Anzeigedisplays von seiner Ausgangsstellung in seine Betätigungsstellung gewährleisten. Der Führungsrahmen umgibt das Anzeigedisplay dazu besonders bevorzugt vollständig in seinem Randbereich, da auf diese Weise eine besonders stabile Lagerung erreicht wird.

Um den von unterschiedlichen Bedienern aufgebrachten unterschiedlichen Bedienkräften gerecht zu werden, ist der Verstellweg des Anzeigedisplays in Richtung auf das Schaltelement idealerweise durch einen Anschlag begrenzt. Der Anschlag verhindert zudem, dass das Anzeigedisplay zu weit in das Gehäuse hinein bewegt wird und dabei beispielsweise Schäden erleidet. Der Anschlag kann beispielsweise dadurch ausgebildet sein, dass ein Vorsprung im Gehäuse vorhanden ist, gegen den der Führungsrahmen des Anzeigedisplays anschlägt. Im praktischen Einsatz hat es sich gezeigt, dass eine steuerbare Ausbildung des Anschlags besonders geeignet ist. Ein steuerbarer Anschlag zeichnet sich dadurch aus, dass er eine Arretierung des Anzeigedisplays optional auch in der Ausgangsstellung (das Notsignal nicht auslösende Normalstellung) gestattet, so dass das Anzeigedisplay beispielsweise zu nachstehend noch weiter angegebenen Programmier-, Installations- oder Codeeingaben, festgestellt werden kann und dadurch eine unbeabsichtigte mechanische Betätigung des Schaltelementes während dieser Arbeiten sicher vermieden wird. Selbstverständlich ist es auch möglich, zusätzlich zu dem Begrenzungsanschlag für das Anzeigedisplay einen separaten und optional hinzuschaltbaren Feststellanschlag zur Arretierung des Anzeigedisplays in der das Schaltelement nicht betätigenden Ausgangsstellung vorzusehen.

Auch die konkrete Ausbildung des Anzeigedisplays kann variieren. Neben einem beleuchteten Anzeigedisplay hat sich insbesondere die Verwendung eines selbstleuchtenden Anzeigedisplays als bevorzugt erwiesen.

Ein weiterer Aspekt der Erfindung liegt nun darin, dass das Anzeigedisplay multifunktional ausgebildet ist und dazu annäherungs- und/oder berührungssensitive Elemente umfasst. Diese können beispielsweise konkret hinter der bildgebenden Einrichtung des Anzeigedisplays angeordnet sein. Durch die Integration von annäherungs- und/oder berührungssensitiven Elementen wird letztendlich eine Ausbildung des Anzeigedisplays in Form eines Touchscreens erhalten, wodurch die Umsetzung umfangreicher Zusatzfunktionen gelingt und das mögliche Einsatzspektrum zusätzlich erweitert wird. Durch die Ausbildung des Anzeigedisplays als Touchscreen mit annäherungs- und/oder berührungssensitiven Elementen kann konkret beispielsweise die Abgabe eines Notsignals vor der mechanischen Auslösung des Notsignals durch eine Betätigung des Schaltelementes bereits durch eine Berührung des Anzeigedisplays erreicht werden. Damit gelingt eine besonders schnelle Reaktion der Nottaste auf eine Betätigung durch einen in Gefahr befindlichen Bediener. Diese Ausführungsform setzt voraus, dass die Steuereinheit zur Identifikation einer entsprechenden Berührung des Touchscreens ausgebildet ist und dazu beispielsweise mit einer entsprechenden Signalübertragungsleitung mit dem Anzeigedisplay verbunden ist. Das mechanisch betätigbare Schaltelement ist in der Regel ferner nach außen hin optisch vom Anzeigedisplay verdeckt. Für diese konkrete Ausführungsform ist es daher ferner besonders bevorzugt, wenn im Anzeigedisplay im Normalbetrieb ein Notschaltknauf, in zweidimensionaler oder räumlicher Darstellung, angezeigt wird, wie er bei den bisher verwendeten, rein mechanisch arbeitenden Nottasten weit verbreitet ist. Der Bediener stößt dadurch im Gefahrenfall auf eine ihm optisch vertraute Ausbildung der Nottaste, was die Benutzerfreundlichkeit besonders erhöht.

Grundsätzlich ist somit eine Ausbildung der Steuereinheit in der Weise möglich, dass sie über eine Annäherung oder Berührung des Anzeigedisplays, beispielsweise zu Programmierungszwecken, ansteuerbar ist. Dazu weist das Anzeigedisplay erfindungsgemäß annäherungs- und/oder berührungssensitive Elemente auf und ist somit ganz besonders als Touchscreen ausgebildet. Neben der bereits dargelegten Auslösung der Abgabe eines Notsignals über das Anzeigedisplay können auf diese Weise grundsätzlich auch eine Vielzahl weiterer Steuerfunktionen über eine Ansteuerung der Steuereinheit durch das Anzeigedisplay realisiert werden. Dies betrifft insbesondere Programmierfunktionen, beispielweise, wenn die Nottaste in ein übergeordnetes Rettungswegleitsystem integriert werden soll. Zur Öffnung einer entsprechenden Menüführung kann es dazu beispielsweise vorgesehen sein, dass bestimmte Bereiche des Anzeigedisplays in einer bestimmten Reihenfolge betätigt werden. Zusammenfassend erleichtert diese Ausführungsform die Bedienung, insbesondere bei Installations- und Wartungsarbeiten, erheblich. So kann beispielsweise auf die bisher im Stand der Technik verwendeten Berechtigungsmittel, wie beispielsweise Freigabeschlüssel, Berechtigungskarten, etc., verzichtet werden, da sämtliche Funktionen im Anzeigedisplay vereint sind.

Insbesondere kann in einer erfindungsgemäßen Ausgestaltung die Auslösung eines Notsignals über eine Berührung/Annäherung an das Anzeigedisplay und über eine Druckbetätigung des mechanischen Schalters über eine Verschiebung des Anzeigedisplays kaskadiert zueinander erfolgen. Dies gelingt beispielsweise dann, wenn der Berührung/Annäherung an das Anzeigedisplay eine Voralarmfunktion und der mechanischen Betätigung des Schaltelementes eine Hauptalarmfunktion zugeordnet wird. Der Voralarm ist im Wesentlichen dadurch gekennzeichnet, dass er dem Bediener bei einer Annäherung/Berührung des Anzeigedisplays ein Alarmsignal angibt beziehungsweise einen Hinweis vermittelt, dass eine Fortsetzung der Bewegung einen Alarm auslösen wird. Dies kann beispielsweise akustisch und/oder über eine entsprechende Anzeige und/oder einen Warnhinweis auf dem Anzeigedisplay erfolgen. Dadurch kann beispielsweise einer ungewollten Auslösung eines Hauptalarms wirksam vorgebeugt werden. Beendet der Bediener während der Voralarmphase die Berührung/Annäherung des Anzeigedisplays, wird der Voralarm wieder abgebrochen. Der Hauptalarm wird dagegen erst dann aktiviert, wenn das mechanische Betätigungselement über eine Bewegung des Anzeigeelementes betätigt worden ist. Lässt der Bediener erst bei einer Auslösung des Hauptalarms vom Anzeigedisplay ab, wird der Hauptalarm idealerweise fortgesetzt und kann erst durch spezielle Abschaltmaßnahmen abgestellt werden. Eine solche Abschaltmaßnahme kann beispielsweise darin bestehen, dass über das Anzeigedisplay ein festgelegter Abschaltcode eingegeben wird. Ergänzend oder alternativ kann auch ein geeigneter Schlüsselschalter oder Ähnliches zum Abschalten des Hauptalarms vorhanden sein. Wesentlich ist. dass der Hauptalarm nur durch eine entsprechend autorisierte Person abgeschaltet werden kann.

Grundsätzlich ist es vorteilhaft, wenn die Nottaste dazu beispielsweise eine lösbare Arretiereinrichtung aufweist, die das Schaltelement im mechanisch betätigten Zustand feststellt. Die Arretiereinrichtung stellt somit sicher, dass das mechanische Schaltelement im betätigten Zustand zur Abgabe des Notsignals solange betätigt bleibt, bis durch ein Lösen der Arretiereinrichtung der Alarm wieder unterbrochen wird. Dies ist insbesondere bei der Verwendung der erfindungsgemäßen Nottaste als Panikschalter vorteilhaft. Ein Panikschalter steuert beispielsweise ergänzend zur Auslösung eines Alarms weitere Elemente, wie beispielsweise eine Türverriegelung. Durch eine Betätigung des Panikschalters kann somit beispielsweise eine Türverriegelung aufgehoben werden, um in Panik befindlichen Personen die Flucht aus einem Gefahrenbereich zu ermöglichen. Die Arretiereinrichtung stellt in diesem Fall sicher, dass der Alarm und beispielsweise eine Türfreigabe aufrecht erhalten bleiben und dadurch eine dauerhafte Freischaltung im Notfall gewährleistet ist. Eine Rückstellung des mechanisch betätigbaren Schaltelementes ist erst mit einem autorisierten Lösen der Arretiereinrichtung möglich. Die konkrete Ausbildung der Arretiereinrichtung kann mannigfaltig variieren. Neben rein mechanischen Rastvarianten haben sich insbesondere auch Arretiereinrichtungen besonders bewährt, die ein steuerbares Arretierglied, wie beispielsweise einen elektromechanisch steuerbaren Sperrbolzen/Anker, aufweisen. Noch einfacher im Aufbau sind rein elektromagnetische Alternativen. Zentrales Merkmal der elektromechanischen und elektromagnetischen Ausführungsformen ist, dass sie jeweils einen Elektromagneten umfassen, der idealerweise über die Steuereinheit angesteuert werden kann und dadurch zur Feststellung/Freigabe der Arretiereinrichtung aktivierbar und deaktivierbar ist, wobei die Steuereinheit insbesondere über Steuerbefehle gesteuert wird, die über das Anzeigedisplay von außerhalb der Nottaste eingegeben werden.

Das Lösen der Arretiereinrichtung beziehungsweise das Aufheben der Feststellung des mechanisch betätigbaren Schaltelementes kann somit auf verschiedene Arten und Weisen erfolgen, wobei stets sicherzustellen ist, dass nur autorisierte Personen den arretierenden Zustand der Arretiereinrichtung lösen können. Bewährt hat sich hierzu beispielsweise ein Schlüsselschalter, der durch einen entsprechenden Schlüssel betätigbar ist. Ideal ist es allerdings, wenn hierzu keine zusätzlichen Komponenten erforderlich sind. Die Arretiereinrichtung ist erfindungsgemäß daher bevorzugt insbesondere in der Weise ausgebildet, dass die Steuerung der Arretiereinrichtung, speziell ihre Entsperrung aus dem arretierenden Zustand. über Steuerbefehle erfolgt, die über das Anzeigedisplay eingegeben werden, insbesondere zur Steuerung eines Elektromagneten der Arretiereinrichtung gemäß den vorstehenden Ausführungen. Der Vorteil dieser Ausführungsform liegt unter anderem darin, dass zur Entsperrung der Arretiereinrichtung keine zusätzlichen Mittel erforderlich sind.

Weitere bevorzugte Ausführungsformen der Nottaste zeichnen können sich beispielsweise dadurch auszeichnen, dass sie weitere Funktionen in sich vereinen. Insbesondere für den Einsatz in sicherheitsrelevanten Bereichen hat sich dazu die Integration einer separaten Identifikationseinheit in das Gehäuse bewährt. Dies gelingt besonders günstig, wenn es sich bei der Identifikationseinheit um einen RFID-Leser (Radio-Frequency Identification) handelt, der zur Identifikation entsprechender Transponderelemente, wie beispielsweise Zugangskarten, etc., ausgebildet ist.

Vorzugsweise ist das Anzeigedisplay mit berührungs- und/oder annäherungssensitiven Elementen in unterschiedliche Betätigungszonen unterteilt, die gleichzeitig oder teilweise betätigt und von der Steuereinheit erkannt werden können. Dies ermöglicht es beispielsweise, bestimmten Arealen der Bedienfläche des Anzeigedisplays bestimmte Funktionen zuzuordnen. So kann beispielsweise eine alleinige Aktivierung eines Eckbereiches des Anzeigedisplays ein Programmierungsmenü öffnen, eine flächige Betätigung oder gleichzeitige Betätigung mehrerer Betätigungszonen ein Notsignal, beispielsweise in Form eines Voralarms, auslösen.

Die Lösung der Aufgabe gelingt ferner mit einer Nottaste zur Abgabe eines Notsignals, umfassend ein Gehäuse, wobei ein berührungssensitives Anzeigedisplay vorhanden ist. über dessen Betätigung eine Abgabe des Notsignals erfolgt. Bei dieser Ausführungsform kommt es somit im Wesentlichen auf das Vorhandensein des berührungssensitiven Anzeigedisplays beziehungsweise Touchscreens an. Eine bewegliche Lagerung des Anzeigedisplays am Gehäuse ist bei dieser Ausführungsform nicht zwingend vorgesehen, kann jedoch selbstverständlich vorhanden sein. Alternativ kann jedoch auch ergänzend ein von außen direkt manuell betätigbares Schaltelement vorhanden sein, um eine Fail-Safe-Funktionalität zu gewährleisten. Für bevorzugte Ausführungsformen dieser Nottaste wird auf die vorstehenden Ausführungen Bezug genommen, sofern dies technisch möglich ist.

Eine Ausführung kann ein Türterminal mit einer Nottaste gemäß den vorhergehenden Ausführungen vorsehen. Bei einem Türterminal handelt es sich allgemein um eine Vorrichtung, die zur Schließkontrolle einer Fluchtwegtür ausgebildet ist. Türterminals finden beispielsweise häufig bei Gebäudeausgangstüren Einsatz. Diese Türen werden im Normalfall beispielsweise verriegelt gehalten. Durch eine Betätigung des im Gebäudeinneren angeordneten Türterminals kann die Verriegelung im Gefahrenfall aufgehoben werden und dadurch ein schnelles Verlassen des Gebäudes erreicht werden. Dazu sind Türterminals häufig in unmittelbarer Nähe solcher Fluchttüren angeordnet, üblich erweise auf Lichtschalterhöhe. Bei einem gattungsgemäßen Türterminal handelt es sich somit um eine, unter Umständen modulartig, aufgebaute Gesamtheit, die zur Verriegelungs- bzw. Entriegelungssteuerung einer Fluchtwegtür vorgesehen ist. Besonders bevorzugt weist der erfindungsgemäße Türterminal ein Gehäuse auf, in dem die Nottaste eingelassen ist. Die vorhergehenden Ausführungen zur erfindungsgemäßen Nottaste gelten selbstverständlich auch für ein erfindungsgemäßes Türterminal mit einer solchen Nottaste.

Die Lösung der Aufgabe gelingt auch mit einem Verfahren zum Betrieb einer Nottaste mit einer Steuereinheit und einem Anzeigedisplay mit annäherungs- und/oder berührungssensitiven Elementen. Es wird durch eine Berührung des Anzeigedisplays zunächst ein Voralarm und erst bei anschließender Betätigung des mechanischen Schaltelementes ein Hauptalarm ausgelöst. Hierzu wird Bezug auf die vorstehenden Ausführungen genommen. Das erfindungsgemäße Verfahren zeichnet sich somit dadurch aus, dass die Abgabe eines Notsignals einerseits auf elektronischem Wege und, dieser Auslösung insbesondere nachgeschaltet, andererseits mechanisch über eine indirekte Betätigung des Schaltelementes durch eine Bewegung des Anzeigedisplays möglich ist.

Ein Aspekt der Erfindung liegt somit darin, dass die elektronische Auslösung des Notsignals durch ein Berühren des oder Annähern an das Anzeigedisplay erfolgt. Das Anzeigedisplay ist somit mit annäherungs- und/oder berührungssensitiven Elementen, insbesondere in Form eines Touchscreens, ausgebildet.

Der Verfahrensschritt der mechanischen Auslösung kann variieren. Besonders effizient ist es jedoch, wenn die mechanische Auslösung durch ein manuelles Bewegen des Anzeigedisplays in Richtung auf das mechanisch betätigbare Schaltelement erfolgt. Insbesondere für den Fall, dass die elektronische Auslösung des Notsignals durch ein Berühren des Anzeigedisplays vorgesehen ist, zeichnet sich diese Ausführungsform dadurch aus, dass sowohl die elektronische als auch die mechanische Auslösung des Notsignals über das Anzeigedisplay (einmal durch Annäherung und/oder Berührung und anschließend durch eine Bewegung des Anzeigedisplays auf das Schaltelement) erfolgt.

Eine Weiterbildung des erfindungsgemäßen Verfahrens liegt darin, dass die Programmierung der Steuereinheit über Steuerbefehle erfolgt, die über das Anzeigedisplay eingegeben werden. Bei diesem Verfahren erfolgt somit nicht nur die Auslösung des Alarmsignals über das Anzeigedisplay, sondern zusätzlich können Programmierungsfunktionen, wie beispielsweise die Einbindung des Nottasters in ein übergeordnetes Rettungswegleitsystem, über das Anzeigedisplay erfolgen.

Bevorzugt umfasst das erfindungsgemäße Verfahren das Steuern einer Arretiereinrichtung, die die Nottaste im mechanisch betätigten Zustand feststellt, wobei die Steuerbefehle, insbesondere zum Lösen der im arretierenden Zustand befindlichen Arretiereinrichtung, über das Anzeigedisplay eingegeben werden. Ganz besonders erfolgt somit die Steuerung der Freigabe des Schaltelementes aus dem betätigten und durch die Arretiereinrichtung im betätigten Zustand festgestellten Stellung über das Eingeben eines entsprechenden Steuerbefehls über das Anzeigedisplay. Dies kann beispielsweise die Eingabe eines Steuercodes und/oder das Betätigen eines bestimmten Areals des Anzeigedisplays sein.

Die Lösung der Aufgabe gelingt schließlich auch durch die Verwendung eines annäherungssensitiven und/oder berührungssensitiven Anzeigedisplays für einen Notschalter, insbesondere einen vorstehend dargelegten Notschalter. Die Verwendung des Anzeigedisplays erfolgt dabei in der Weise, dass die Auslösung eines Notsignals über das bewegbar gelagerte Anzeigedisplay sowohl elektronisch als auch mechanisch möglich ist. Weiter bevorzugt wird das Anzeigedisplay ferner zur Eingabe wenigstens eines Steuerbefehls, insbesondere zur Programmierung zu Installations- und Wartungszwecken, genutzt. Die erfindungsgemäße Verwendung sieht somit insbesondere auch die Anwendung eines erfindungsgemäßen Verfahrens vor.

Nachfolgend wird die Erfindung anhand der in den Figuren dargestellten bevorzugten Ausführungsbeispiele schematisch näher erläutert. Es zeigen:
- Fig. 1:: eine perspektivische Schrägansicht auf einen Notschalter;
- Fig.2:: eine Seitenquerschnittsansicht durch den Notschalter aus Fig. 1 in Ausgangsstellung;
- Fig.3:: den Notschalter aus Fig. 2 in Betätigungsstellung;
- Figuren 4a bis 4c:: verschiedene Anzeige- und Funktionszustände des Notschalters;
- Fig. 5a:: eine alternative Ausführungsform eines Notschalters mit Arretiereinrichtung; und
- Fig. 5b:: Ausschnitt der Arretiereinrichtung aus Fig. 5a im arretierenden Zustand.

Gleiche Bauteile sind nachstehend mit gleichen Bezugszeichen gekennzeichnet.

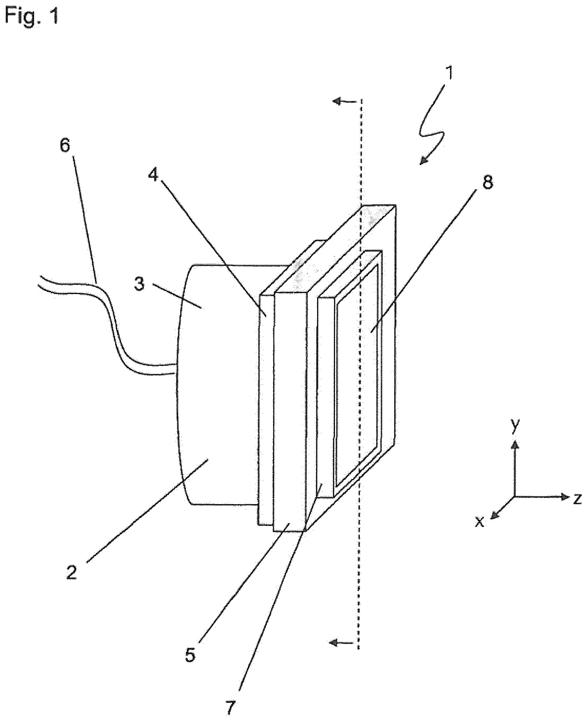

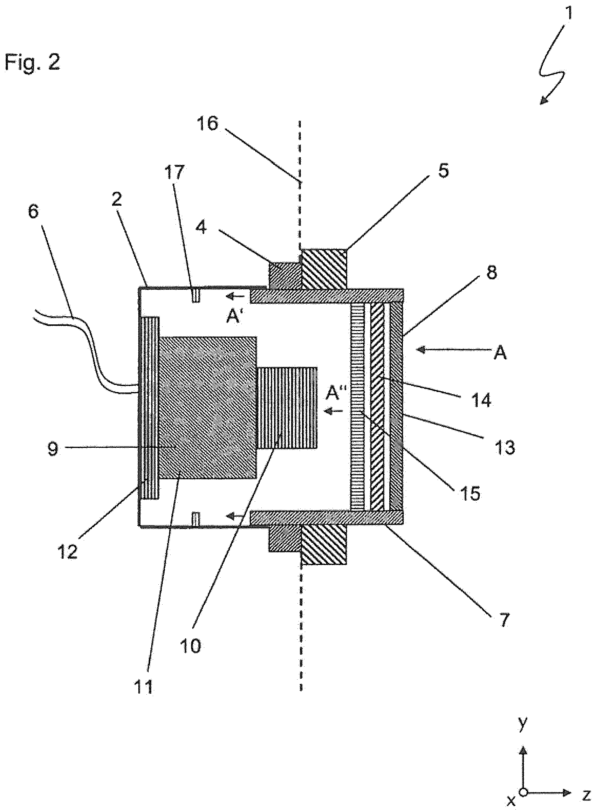

Fig. 1 betrifft eine perspektivische Schrägansicht auf eine Nottaste 1. Die Nottaste 1 umfasst ein Gehäuse 2 mit einem Gehäuseunterteil 3, einem Befestigungsrahmen 4 und einem Abdeckrahmen 5. In der dargestellten Ausführungsform ist das Gehäuseunterteil 3 als Unterputzdose ausgebildet und wird beim Einbau in die entsprechende Installationswand versenkt. Der Abdeckrahmen 5 steht im installierten Zustand über die Wandoberfläche nach außen vor. Die Verkabelung der Nottaste 1 erfolgt über Leitungen 6, die nach hinten aus dem Gehäuseunterteil 3 herausgeführt sind. Nach vorn bzw. aus Sicht des Betrachters erfolgt der Abschluss des Gehäuses 2 durch die Außenoberfläche eines in einem Führungsrahmen gelagerten Anzeigedisplays 8. Weitere Einzelheiten zum Aufbau der Nottaste 1 ergeben sich aus der Querschnittsansicht in der YZ-Richtung gemäß Fig. 2, wobei die Schnittlinie in Fig. 1 gestrichelt angegeben ist.

Im Inneren des Gehäuses 2 ist ein Schaltelement 9, umfassend einen Notschaltknopf 10, einen Notschaltergrundkörper 11 und eine Elektronikplatine 12, angeordnet. Die Elektronikplatine 12 ist die Steuereinheit des Notschalters 1 und ist dazu sowohl mit dem Notschaltknopf 10 als auch mit dem Anzeigedisplay 8 und den darin integrierten Funktionselementen verbunden (in den Figuren nicht weiter angegeben). Das Anzeigedisplay 8 umfasst ein nach außen gerichtetes Bildschirmelement 13, eine in Richtung Schalterinneres dahinterliegende annäherungsempfindliche Schaltfläche 14 und einen Identifikationsleser 15 (konkret ein RFID-Leser). Insgesamt ist das Anzeigedisplay 8 somit als ein Tastschirm bzw. Touchscreen ausgebildet, wobei die Elemente 13, 14 und 15 eine baulich zusammenhängende Einheit darstellen, die in dem Führungsrahmen 7 fest installiert ist. Die Gesamtheit aus Führungsrahmen 7 und dem Anzeigedisplay 8 ist gegenüber den übrigen Komponenten des Notschalters 1, insbesondere gegenüber dem Gehäuse 2, längsverschieblich aus der in Fig. 2 gezeigten Position in Richtung auf den Notschaltknopf 10 gelagert. Diese Bewegungsrichtung ist in Fig. 2 mit dem Pfeil A "Betätigungsrichtung" dargestellt. Die Pfeile A' und A" geben an, wie sich das Anzeigedisplay 8 zusammen mit dem Führungsrahmen 7 bei einer Verschiebung durch manuelle Betätigung von Außen in das Innere des Notschalters 1 bewegt.

In Fig. 2 ist ferner die Außenoberfläche 16 einer Wand gestrichelt angedeutet, in die der Notschalter 1 installiert ist. Der Bereich der Notschalters 1 links von der Außenoberfläche liegt dabei im Wandinneren und der Bereich rechts der Außenoberfläche 16 steht über die Außenoberfläche 16 hervor. Die vorliegende Ausführungsform des Notschalters 1 ist somit teilweise unter Putz montiert. Alternativ ist selbstverständlich auch eine vollständige Aufputzvariante möglich.

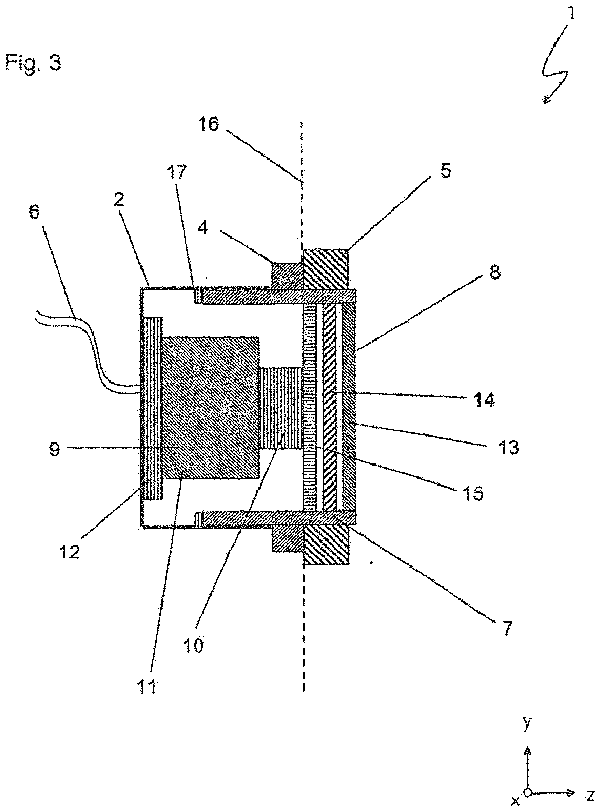

Die konkrete Funktionsweise des Notschalters 1 zur Abgabe eines Notsignals ergibt sich näher aus einer Zusammenschau der Figuren 2 und 3. Fig. 2 gibt dabei die Ausgangsstellung beziehungsweise den Normalzustand des Notschalters 1 wieder, wohingegen Fig. 3 die mechanische Betätigungsstellung angibt, in der das Anzeigedisplay 8 zusammen mit dem Führungsrahmen 7 soweit in das Gehäuse 2 des Notschalters 1 eingedrückt ist, dass der Notschaltknopf 10 betätigt ist.

Im Normalzustand befindet sich der Notschalter 1 in der in Fig. 2 gezeigten Position. Tritt ein Gefahrenfall ein, kann eine im Gefahrenbereich befindliche Person über den Notschalter 1 ein Notsignal auslösen. Dies gelingt vorliegend in einer ersten Stufe durch eine Berührung des Anzeigedisplays 8 mit der Hand, die über die annäherungsempfindliche Schaltfläche 14 detektiert wird und entsprechend von der Steuereinheit bzw. der Elektronikplatine 12 verarbeitet wird. Um der jeweiligen Person die Bedienung des Notschalters 1 zu erleichtern, kann im Normalfall dazu beispielsweise ein regulärer Notknopf, je nach Einstellung zweidimensional oder dreidimensional, im Anzeigedisplay 8 angezeigt werden. Sobald ein Notsignal abgesetzt wird, kann dies über das Anzeigedisplay 13 angezeigt werden, beispielsweise durch eine Farbänderung, einen Texthinweis, einen blinkenden Hintergrund, etc.

Für den Fall, dass die Funktionsintegrität der annäherungsempfindlichen Schaltfläche 14 nicht mehr vorliegen sollte, steht der im Gefahrenbereich befindlichen Person als weitere, "nachgeschaltete" Möglichkeit eine Bewegung des Führungsrahmens 7 inklusive des darin angeordneten Anzeigedisplays 8 in Richtung auf den Notschaltknopf 10 zur Verfügung. Der Bediener drückt dazu auf das Anzeigedisplay 8 und schiebt, bei fortgesetzter Druckbewegung, den Führungsrahmen 7 zusammen mit dem Anzeigedisplay 8 auf den Notschaltknopf 10, der ab einem gewissen Punkt somit ebenfalls eingedrückt wird. Wird der Schaltpunkt des Notschaltknopfes 10 überschritten, löst dieser ein Notsignal über die Elektronikplatine 12 aus, die vom Notschalter 1 über die Leitungen 6 entsprechend weitergeleitet werden. Wird das Anzeigedisplay 8 somit in Betätigungsrichtung A eingedrückt, kommt bei der vorliegenden Ausführungsform die Rückseite des Identifikationslesers 15 in Kontakt mit dem Notschaltknopf 10 und drückt diesen in Richtung des Notschaltergrundkörpers 11 ein. Zur Begrenzung der Eindrückbewegung sind ferner die Anschlagelemente 17 vorhanden, gegen die die Stirnseite des Führungsrahmens 7 bei maximaler Eindrückstellung anschlagen. Ferner kann eine Federbeaufschlagung vorhanden sein, die den Führungsrahmen 7 zusammen mit dem Anzeigedisplay 8 aus der Eindrückposition in Fig. 3 wieder in die Ausgangsstellung gemäß Fig. 2 zurückdrückt.

Alternativ kann es bei dieser Ausführungsform auch vorgesehen sein, dass bei der Annäherung an beziehungsweise der Berührung des Anzeigedisplays 8 zunächst ein Voralarm ausgelöst wird und ein Hauptalarm erst bei einer Betätigung des mechanischen Schaltelementes 9.

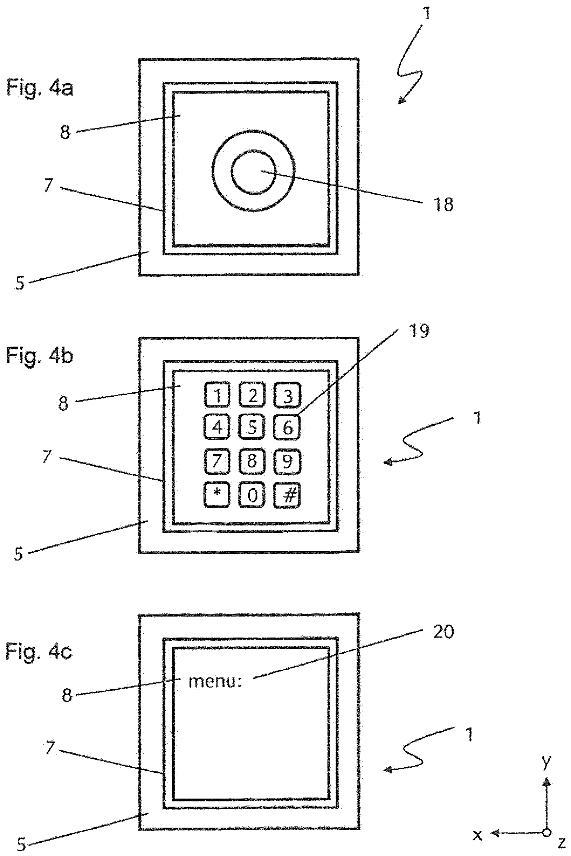

Die Figuren 4a, 4b und 4c zeigen verschiedene Betriebszustände des Anzeigedisplays 8, die den multifunktionellen Charakter des Notschalters 1 weiter verdeutlichen. Die Figuren 4a, 4b und 4c sind dabei Frontalansichten auf den Notschalter 1.

Fig. 4a zeigt eine der bevorzugten Standardanzeigen, die im Bildschirmelement 13 des Anzeigedisplays 8 im regulären Betrieb des Notschalters 1 angezeigt werden. Dort ist ein kreisförmiger Notschaltknopf 18 (üblicherweise in rot vor hellem Hintergrund) abgebildet, wie er bei rein mechanischen Notschaltern üblicherweise verwendet wird. Das Anzeigedisplay 8 imitiert somit die Erscheinung eines bisher verwendeten und dem durchschnittlichen Bediener vertrauten Notschalters und bildet diesen auf dem Anzeigedisplay 8 nach. Im Gefahrenfall sieht der Bedienerden Notschalter 1 und wird somit reflexartig auf den abgebildeten Notschaltknopf 18 und damit auf das Anzeigedisplay 8 drücken. Durch die Berührung des Bildschirmelements 13, die von der annäherungsempfindlichen Schaltfläche 14 registriert und an die Steuereinheit (Elektronikplatine 12) weitergeleitet wird, wird bereits ein Notsignal ausgelöst. Sollte die annäherungsempfindliche Schaltfläche 14 defekt sein oder der Bediener in Panik geraten sein, kann er den Druck auf das Anzeigedisplay 8 erhöhen, wodurch letztendlich in der vorstehend beschriebenen Weise der Notschaltknopf 10 betätigt wird, so dass zur Auslösung eines Notsignals über den Notschalter 1 insgesamt eine Redundanzfunktion vorhanden ist.

In Fig. 4b befindet sich der Notschalter 1 im Zutrittskontrollmodus. Dieser kann beispielsweise durch eine Berührung bestimmter Regionen im Anzeigedisplay 8 ausgehend von der Anzeige aus Fig. 4a aufgerufen werden. Das Anzeigedisplay 8 zeigt über das Bildschirmelement 13 in Fig. 4b einen Standardnummernblock 19 an, über den beispielsweise Zutrittscodes, etc., zur Zugangskontrolleingabe eingegeben werden können. Durch die Ausbildung des Anzeigedisplays 8 als Touchscreen bzw. durch das Vorhandensein der annäherungsempfindlichen Schaltfläche 14 ist die Erfassung der eingegebenen Nummernfolge durch ein Antippen des Bildschirmelements 13 an den jeweiligen Stellen möglich. Bei dieser Ausführungsform ist somit auch eine Ansteuerung einer Zutrittskontrollanlage über das Anzeigedisplay 8 der Nottaste 1 möglich.

Fig. 4c schließlich gibt einen weiteren möglichen Betriebszustand wieder. Das Anzeigedisplay 8 zeigt hier angedeutet ein Programmmenü 20 an, über das beispielsweise Programmierfunktionen wahrgenommen werden können. In diesem Fall stellt das Anzeigedisplay 8 somit ein Benutzerinterface dar, welches es beispielsweise einem Installateur ermöglicht, Programmierarbeiten unmittelbar am Notschalter 1 ohne zusätzliche Mittel vorzunehmen. Die Berechtigung dazu kann beispielsweise über die Eingabe eines entsprechenden Berechtigungscodes gemäß Fig. 4b erfolgen. Der Notschalter 1 kann zum Aufruf des Programmierzustandes ebenso in der Weise ausgebildet sein, dass das Berühren bestimmter Bereiche des Anzeigedisplays 8 zum Aufruf dieser Funktion führt.

Selbstverständlich sind weitere Betriebszustände und Funktionszustände möglich und von der Erfindung mit umfasst. Dies betrifft beispielsweise die Anzeige weiterer oder alternativer Informationen über das Anzeigedisplay, wie beispielsweise die Anzeige von Warnmeldungen ("Feuer"), Fluchtwegleitinformationen, der Sperrung eines Fluchtwegs, die Freigabe einer Fluchttür, die Anzeige einer zeitverzögerten Fluchttürfreigabe, etc. Zudem kann beispielsweise ein Codeeingabe über das Anzeigedisplay 8 zum Lösen einer nachstehend noch weiter angegebenen Arretiereinrichtung erfolgen, die das eingedrückte Anzeigedisplay 8 in der eingedrückten Stellung feststellt, beispielsweise nach dem Auslösen eines Hauptalarms.

Vorliegend ist der Notschalter 1 zudem in der Weise ausgebildet, dass er nach Ablauf eines vorher festgelegten Zeitintervalls automatisch von den in den Figuren 4b und 4c angezeigten Betriebsmodi in den in Fig. 4a angegebenen Normalzustand zurückkehrt. Damit ist gewährleistet, dass nach dem Abschluss von Wartungsarbeiten oder dem Aufruf sonstiger Betriebs- und Funktionszuständen die zentrale Notschalterfunktion automatisch wieder hergestellt ist.

Alternativ oder ergänzend ist insbesondere für den Fall einer Integration der Nottaste 1 in ein Fluchttürsteuerungssystem mit einer Fluchttürverriegelung, beispielsweise einem Fluchttüröffner, auch eine Ausbildung des Nottasters 1 (beziehungsweise dessen Steuereinheit) beziehungsweise eines diesen umfassenden Nottasterterminals in der Weise möglich, dass er eine, beispielsweise in den einschlägigen Normen vorgesehene, zeitverzögerte Fluchtwegfreigabe aufweist.

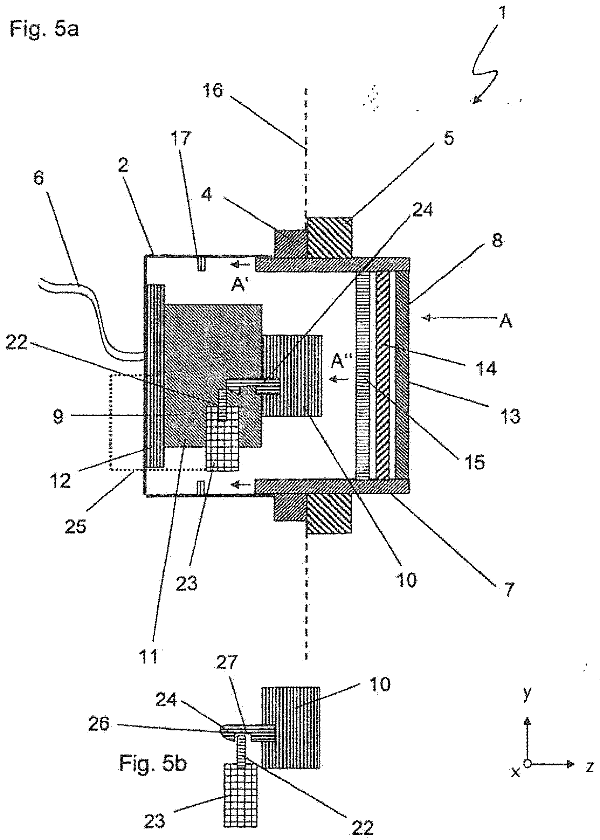

Die Figuren 5a und 5b betreffen eine gegenüber den Figuren 1 bis 3 erweiterte Ausführungsform des Notschalters 1, auf die die Figuren 4a bis 4c gleichermaßen anwendbar sind. Der einzige Unterschied der Ausführungsform gemäß den Figuren 5a und 5b gegenüber dem vorhergehenden Ausführungsbeispiel liegt in dem zusätzlichen Vorhandensein einer Arretiereinrichtung 21. In Bezug auf den sonstigen Aufbau und die Funktionsweise des Notschalters 1 wird entsprechend auf die vorhergehenden Ausführungen Bezug genommen.

Die Arretiereinrichtung 21 hat im Wesentlichen die Aufgabe, eine Feststellung des mechanischen Schaltelements 9 im betätigten Zustand zu bewirken. Die Arretiereinrichtung 21 ist mit anderen Worten in der Weise ausgebildet, dass sie nach einer Betätigung des mechanischen Schaltelementes 9 ein selbsttätiges Rückstellen des Schaltelementes 9 verhindert und die durch die Betätigung des Schaltelementes 9 erreichte Abgabe eines Notsignals aufrechterhält. Grundsätzlich kann die Arretiereinrichtung 21 dazu neben einer rein elektronischen Ausführungsform beispielsweise eine Rasteinrichtung oder ähnliches umfassen und somit teilmechanisch, beispielsweise elektromechanisch, betätigbar sein. Ein wesentlicher Aspekt der Arretiereinrichtung 21 liegt ferner darin, dass sie aus dem arretierenden Zustand zur Freigabe des arretierten Schaltelementes 9 lösbar ist. Auch dies kann elektronisch, mechanisch (beispielsweise mittels eines Schlüsselschalters) und insbesondere elektromechanisch erfolgen. Ideal ist es, wenn die Freischaltung der Arretiereinrichtung 21 über die Eingabe eines entsprechenden Steuerbefehls über das als Touchscreen ausgebildete Anzeigedisplay 8 erfolgt.

In den Figuren 5a und 5b ist beispielhaft eine konkrete Ausführungsform für eine Arretiereinrichtung 21 weiter veranschaulicht. Wesentliche Elemente der Arretiereinrichtung sind ein Anker 22 eines Elektromagneten 23, die im Notschaltergrundkörper 11 angeordnet sind, ein mit den Notschaltknopf 10 verbundener Rasthaken 24 mit einer Gleitschräge 26 und einer Rastausnehmung 27, und eine Signalleitung 25, die den Elektromagneten 23 mit der Elektronikplatine 12 verbindet.

Der Stellweg des federbeaufschlagten Ankers 22 des Elektromagneten 23 verläuft quer zur Stellrichtung des Notschaltknopfes 10. Der Anker 22 ist somit zwischen einer ausgefahrenen Arretierposition (in die die Federbeaufschlagung wirkt) und einer in den Elektromagneten 23 eingefahrenen Freigabeposition verstellbar. Bei einer Bestromung des Elektromagneten 23 verstellt sich der Anker 22 und wird aus dem Stellweg des Rasthakens gezogen.

Bei einer Betätigung des Notschaltknopfes 10 über ein Einschieben des Anzeigedisplays 8 übergleitet der Rasthaken 24 den Anker 22 und schiebt diesen durch seine Gleitschräge 26 quer zur Einschubrichtung des Notschaltknopfes 10 entgegen der Federbeaufschlagung aus seinem Stellweg. Sobald der Notschaltknopf 10 soweit eingedrückt ist, dass die Rastausnehmung 27 auf Höhe des Ankers 22 ist, schnellt dieser durch seine Federbeaufschlagung getrieben nach vorn in die Rastausnehmung 27 hinein. Eine Rückstellung des Notschaltknopfes 10, beispielsweise ebenfalls durch eine geeignete Federbeaufschlagung angetrieben, wird durch diese Verrastung unterbunden, der Notschaltknopf wird entsprechend in seiner eingeschobenen Position arretiert.

Zur Freigabe des Notschalknopfes 10 ist entsprechend eine kurzzeitige Bestromung des Elektromagneten 23 erforderlich. Hierzu wird über das Anzeigedisplay mithilfe der annäherungsempfindlichen Schicht 14 zusammen mit dem Bildschirmelement 13 die Eingabe eines verifizierten Codes (beispielsweise durch Anzeige gemäß Fig. 4b) abgefragt. Die erhaltenen Informationen werden anschließend von der Elektronikplatine verarbeitet und, sofern ein korrekter Code eingegeben wurde, veranlasst die Elektronikplatine 12 eine kurzfristige Bestromung des Elektromagneten 23. Dadurch wird der Anker 22 aus seiner Arretierstellung in die Freigabestellung gezogen, gibt den Rasthaken 24 frei und der Notschaltknopf 10 schnellt (federgetrieben) wieder in seine ausgefahrene Ausgangsposition. Insgesamt wird mit der Arretiereinrichtung 21 somit eine Möglichkeit geschaffen, dass eine Unterbrechung eines Alarms nur mit Hilfe einer entsprechend autorisierten Person erfolgt, so dass gewährleistet ist, dass der Alarm erst nach einem Beheben der Alarmsituation erfolgt.

## Patentansprüche

1. Nottaste zur Abgabe eines Notsignals, umfassend
ein Gehäuse (2),
ein im Gehäuse angeordnetes Schaltelement (9), und
ein bewegbar am Gehäuse gelagertes und von einer Steuereinheit angesteuertes Anzeigedisplay (8),
wobei das Schaltelement (9) über eine Bewegung des Anzeigedisplays (8) mechanisch betätigbar ist, und
das Anzeigedisplay (8) annäherungs- und/oder berührungssensitive Elemente aufweist, **dadurch gekennzeichnet,**
**dass** die Nottaste als Panikschalter ausgebildet ist und eine Türverriegelung steuert, indem
die Auslösung eines Notsignals kaskadiert über eine Berührung des Anzeigedisplays (8) oder eine Annäherung an das Anzeigedisplay (8) und über eine Druckbetätigung des mechanischen Schaltelements (9) mittels einer Verschiebung des Anzeigedisplays (8) erfolgt, wobei der Berührung des Anzeigedisplays (8) oder einer Annäherung an das Anzeigedisplay (8) eine Voralarmfunktion durch eine Abgabe des Voralarms akustisch und/oder über einen Warnhinweis und/oder eine Anzeige auf dem Anzeigedisplay erfolgt, und dass bei der mechanischen Betätigung des Schaltelementes (9) eine Hauptalarmfunktion mit einer Übermittlung eines Öffnungssignals an ein Verschluss- oder Verriegelungselement zur Aufhebung der Tüverriegelung erfolgt.

2. Nottaste nach Anspruch 1,
**dadurch gekennzeichnet,**
**dass** eine lösbare Arretiereinrichtung (21) vorgesehen ist, die das Schaltelement (9) im mechanisch betätigten Zustand feststellt.

3. Nottaste nach Anspruch 2,
**dadurch gekennzeichnet,**
**dass** die Steuerung der Arretiereinrichtung (21), insbesondere die Entsperrung, über Steuerbefehle erfolgt, die über das Anzeigedisplay (8) eingegeben werden.

4. Nottaste nach einem der vorhergehenden Ansprüche,
**dadurch gekennzeichnet,**
**dass** das Lösen der Arretiervorrichtung (21) über einen Schlüsselschalter, der durch einen entsprechenden Schlüssel betätigbar ist, erfolgt.

5. Nottaste nach einem der vorhergehenden Ansprüche,
**dadurch gekennzeichnet,**
**dass** das Anzeigedisplay (8) als Touchscreen ausgebildet ist.

6. Nottaste nach einem der vorhergehenden Ansprüche,
**dadurch gekennzeichnet,**
**dass** eine Steuereinheit über eine Berührung und/oder Annäherung des Anzeigedisplays (8) ansteuerbar ist, vorzugsweise zu Programmierungszwecken ansteuerbar ist.

7. Türterminal mit einer Nottaste nach einem der vorhergehenden Ansprüche.

8. Verfahren zum Betrieb einer als Panikschalter verwendeten Nottaste, wobei die Nottaste
ein Gehäuse,
ein im Gehäuse (2) angeordnetes Schaltelement (9), und
ein bewegbar am Gehäuse gelagertes und von einer Steuereinheit angesteuertes Anzeigedisplay (8) aufweist,
und das Schaltelement über eine Bewegung des Anzeigedisplays mechanisch betätigt wird,
**dadurch gekennzeichnet,**
**dass** durch eine Berührung des Anzeigedisplays (8) oder eine Annäherung an das Anzeigedisplay (8) zunächst ein Voralarm ausgelöst und akustisch und/oder über eine entsprechende Anzeige und/oder einen Warnhinweis auf dem Anzeigedisplay (8) abgegeben wird und erst bei anschließender Betätigung des mechanischen Schaltelements (9) ein Hauptalarm ausgelöst und eine Türverriegelung aufgehoben wird.

9. Verfahren nach Anspruch 8,
**dadurch gekennzeichnet,**
**dass** das Anzeigedisplay (8) zum Auslösen des Hauptalarms eingedrückt und über eine Arretiereinrichtung (21) in der eingedrückten Stellung festgehalten wird.

10. Verfahren nach Anspruch 8 oder 9,
**dadurch gekennzeichnet,**
**dass** in einem regulären Betriebszustand in einem Bildschirmelement (13) des Anzeigedisplays (8) ein kreisförmiger Notschalter (18) abgebildet wird.

11. Verfahren nach einem der Ansprüche 8 bis 10,
**dadurch gekennzeichnet,**
**dass** in einem Zutrittskontrollmodus in einem Bildschirmelement (13) des Anzeigedisplays (8) ein Standardnummernblock (19) angezeigt wird.

12. Verfahren nach einem der Ansprüche 8 bis 11,
**dadurch gekennzeichnet,**
**dass** in einem Betriebszustand über das Anzeigedisplay (8) Warnmeldungen und/oder Fluchtwegleitinformationen angezeigt werden.

13. Verfahren nach einem der Ansprüche 8 bis 12,
**dadurch gekennzeichnet,**
**dass** in einem Betriebszustand über das Anzeigedisplay (8) ein Code zum Lösen der Arretiereinrichtung (21) eingegeben wird.

## Claims

1. Emergency button for emitting an emergency signal, comprising
a housing (2)
a switching element (9) arranged in the housing, and
a display screen (8) movably mounted on the housing and controlled by a control unit, wherein the switching element (9) can be mechanically activated by means of a movement of the display screen (8), and
the display screen (8) has proximity and/or touch-sensitive elements,
**characterised in that**
the emergency button is formed as a panic switch and controls a door locking mechanism by
triggering an emergency signal cascading by means of the display screen (8) being touched, or by an approximation to the display screen (8), and by means of a push activation of the mechanical switching element (9) occurring by means of a movement of the display screen (8), wherein, upon touching the display screen (8) or an approximation to the display screen (8), a pre-alarm function is activated acoustically and/or via a warning and/or a notification on the display screen by means of emitting the pre-alarm, and that, upon the mechanical activation of the switching element (9), a main alarm function is activated by transmitting an open signal to a closing or locking element to unlock the door locking mechanism.

2. Emergency button according to claim 1,
**characterised in that**
a releasable lock-off device (21) is provided that holds the switching element (9) in the mechanically activated state.

3. Emergency button according to claim 2,
**characterised in that**
controlling the lock-off device (21), especially unlocking, is carried out via control commands that are input via the display screen (8).

4. Emergency button according to one of the preceding claims,
**characterised in that**
releasing the lock-off device (21) takes place by means of a key switch that can be activated by a corresponding key.

5. Emergency button according to one of the preceding claims,
**characterised in that**
the display screen (8) is formed as a touch screen.

6. Emergency button according to one of the preceding claims,
**characterised in that**
a control unit can be controlled by touching and/or an approximation to the display screen (8), and can preferably be controlled for programming purposes.

7. Door terminal having an emergency button according to one of the preceding claims.

8. Method for operating an emergency button used as a panic switch, wherein the emergency button has
a housing,
a switching element (9) arranged in the housing (2), and
a display screen (8) movably mounted on the housing and controlled by a control unit, and the switching element is activated by means of a movement of the display screen, **characterised in that**
by touching the display screen (8) or an approximation to the display screen (8), firstly a pre-alarm is triggered and emitted acoustically and/or by means of a corresponding notification and/or warning on the display screen (8), and that a main alarm is triggered and a door locking mechanism unlocked only if the mechanical switching element (9) is subsequently activated.

9. Method according to claim 8,
**characterised in that**
the display screen (8) is pushed in to trigger the main alarm, and held in the pushed-in position by means of a lock-off device (21).

10. Method according to claim 8 or 9,
**characterised in that,**
in a regular operating state, a circular emergency switch (18) is shown on a screen element (13) of the display screen (8).

11. Method according to one of the claims 8 to 10,
**characterised in that,**
in an access control mode, a standard numbers block (19) is displayed on a screen element (13) of the screen display (8).

12. Method according to one of claims 8 to 11,
**characterised in that,**
in an operating state, warnings and or escape route information is displayed by means of the display screen (8).

13. Method according to one of claims 8 to 12,
**characterised in that,**
in an operating state, a code to remove the lock-off device (21) is input via the display screen (8).

## Revendications

1. Touche d'urgence pour l'émission d'un signal d'urgence, comprenant
un boîtier (2)
un élément de commutation (9) disposé dans le boîtier et
un écran d'affichage (8) logé de manière mobile sur le boîtier et contrôlé par une unité de commande,
l'élément de commutation (9) pouvant être actionné mécaniquement par un mouvement de l'écran d'affichage (8) et
l'écran d'affichage (8) comprenant des éléments sensibles à la proximité et/ou au contact,
**caractérisée en ce que**
la touche d'urgence est conçue comme un interrupteur de panique et commande un verrouillage de porte
grâce au fait que le déclenchement d'un signal d'urgence a lieu en cascade par l'intermédiaire d'un contact de l'écran d'affichage (8) ou d'un rapprochement de l'écran d'affichage (8) et par l'intermédiaire d'un actionnement par pression de l'élément de commutation mécanique (9) au moyen d'un déplacement de l'écran d'affichage (8), moyennant quoi, lors d'un contact avec l'écran d'affichage (8) ou d'un rapprochement vers l'écran d'affichage (8), une fonction de pré-alarme est déclenchée par une émission de la pré-alarme de manière acoustique et/ou par un avertissement et/ou par un affichage sur l'écran d'affichage et **en ce que** lors de l'actionnement mécanique de l'élément de commutation (9), une fonction d'alarme principale étant déclenchée avec une transmission d'un signal d'ouverture à un élément de fermeture ou de verrouillage pour le relâchement du verrouillage de la porte.

2. Touche d'urgence selon la revendication 1,
**caractérisée en ce que**
un dispositif de blocage relâchable (21) est prévu, qui maintient l'élément de commutation (9) dans l'état actionné mécaniquement.

3. Touche d'urgence selon la revendication 2,
**caractérisée en ce que**
la commande du dispositif de blocage (21), plus particulièrement le déblocage, a lieu par l'intermédiaire d'instructions de commande, qui sont entrées par l'intermédiaire de l'écran d'affichage (8).

4. Touche d'urgence selon l'une des revendications précédentes,
**caractérisée en ce que**
le relâchement du dispositif de blocage (21) a lieu par l'intermédiaire d'un interrupteur à clé, qui peut être actionné par une clé correspondante.

5. Touche d'urgence selon l'une des revendications précédentes,
**caractérisée en ce que**
l'écran d'affichage (8) est conçu comme un écran tactile.

6. Touche d'urgence selon l'une des revendications précédentes,
**caractérisée en ce que**
une unité de commande peut être contrôlée par un contact et/ou un rapprochement de l'écran d'affichage (8), de préférence à des fins de programmation.

7. Terminal de porte avec une touche d'urgence selon l'une des revendications précédentes.

8. Procédé d'exploitation d'une touche d'urgence utilisée en tant qu'interrupteur de panique, la touche d'urgence comprenant
un boîtier,
un élément de commutation (9) disposé dans le boîtier (2) et
un écran d'affichage (8) logé de manière mobile sur le boîtier et contrôlé par une unité de commande,
et l'élément de commutation est actionné mécaniquement par l'intermédiaire d'un déplacement de l'écran d'affichage,
**caractérisé en ce qu'**un contact de l'écran d'affichage (8) ou un rapprochement de l'écran d'affichage (8) déclenche d'abord une pré-alarme qui est émise de manière acoustique et/ou par l'intermédiaire d'un affichage correspondant et/ou un avertissement est affiché sur l'écran d'affichage (8) et une alarme principale n'est déclenchée et un verrouillage de porte n'est supprimé que lors de l'actionnement de l'élément de commutation mécanique (9).

9. Procédé selon la revendication 8,
**caractérisé en ce que**
l'écran d'affichage (8) est actionné pour le déclenchement de l'alarme principale et est maintenu dans la position actionnée par un dispositif de blocage (21).

10. Procédé selon la revendication 8 ou 9,
**caractérisé en ce que**
dans un état de fonctionnement régulier, dans un élément (13) de l'écran d'affichage (8), un interrupteur d'urgence circulaire (18) est représenté.

11. Procédé selon l'une des revendications 8 à 10,
**caractérisé en ce que**
dans un mode de contrôle d'accès, dans un élément (13) de l'écran d'affichage (8), un bloc numérique standard (19) est affiché.

12. Procédé selon l'une des revendications 8 à 11,
**caractérisé en ce que**
dans un état de fonctionnement, des messages d'avertissement et/ou des informations sur les issues de sortie sont affichées sur l'écran d'affichage (8).

13. Procédé selon l'une des revendications 8 à 12,
**caractérisé en ce que**
dans un état de fonctionnement, un code de déverrouillage du dispositif de blocage (21) est entré par l'intermédiaire de l'écran d'affichage (8).
